(19) Europäisches Patentamt / European Patent Office / Office européen des brevets

(11) **EP 4 730 480 A1**

(12) **EUROPEAN PATENT APPLICATION**
published in accordance with Art. 153(4) EPC

(43) Date of publication:
**22.04.2026 Bulletin 2026/17**

(21) Application number: 24823159.9

(22) Date of filing: **15.05.2024**

(51) International Patent Classification (IPC):
*H01M 10/48* (2006.01)    *B64D 27/24* (2024.01)
*B64U 50/19* (2023.01)    *B64U 80/20* (2023.01)
*H02J 7/00* (2026.01)

(52) Cooperative Patent Classification (CPC):
B64D 27/24; B64U 50/19; B64U 80/20;
H01M 10/48; H02J 7/00

(86) International application number:
**PCT/JP2024/017891**

(87) International publication number:
**WO 2024/257537 (19.12.2024 Gazette 2024/51)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **14.06.2023 JP 2023097930**

(71) Applicant: **DENSO CORPORATION**
**Kariya-city, Aichi 448-8661 (JP)**

(72) Inventors:
• **NAKAMURA, Masaya**
  **Kariya-city, Aichi 448-8661 (JP)**
• **YOSHIDA, Shuhei**
  **Kariya-city, Aichi 448-8661 (JP)**

(74) Representative: **TBK**
**Bavariaring 4-6**
**80336 München (DE)**

(54) **MONITORING DEVICE, MONITORING METHOD, AND PROGRAM**

(57) A monitoring device (50) monitors a battery (14) mounted on an eVTOL. A monitoring device (50) includes an acquisition unit (51) and an output unit (53). An acquisition unit (51) acquires voltage information of the battery (14) during flight and information related to the travel mode of the eVTOL. An output unit (53) outputs monitoring result when a predetermined condition related to an abnormality of the battery (14) is satisfied with reference to the voltage information and a threshold value set for each travel mode. By using the threshold value set for each travel mode, an abnormality of the battery (14) can be detected early, and flight safety can be improved.

**FIG. 8**

**Description**

CROSS REFERENCE TO RELATED APPLICATION

The present application is based on Japanese Patent Application No. 2023-097930 filed on June 14, 2023. The entire disclosures of all of the above applications are incorporated herein by reference.

TECHNICAL FIELD

The present disclosure relates to a monitoring device, a monitoring method, and a program.

BACKGROUND ART

Patent Literature 1 discloses a method for controlling an electric flight vehicle. The disclosure of the prior art document is incorporated herein by reference as an explanation of the technical elements in this disclosure.

PRIOR ART LITERATURE

PATENT LITERATURE

PATENT LITERATURE 1: JP2021-172101A

SUMMARY OF INVENTION

In Patent Literature 1, the battery state is monitored, and once an abnormality such as a short circuit is detected, measures are taken to avoid the abnormality. In the above respects and in other respects not mentioned, further improvements are required in the monitoring device, the monitoring method, and the program.
It is an object of the disclosure to provide a monitoring device that enables to enhance flight safety, a monitoring method, and a program.
One aspect of the disclosure is a monitoring device configured to monitor a battery mounted on an electric flight vehicle. The monitoring device comprises: an acquisition unit configured to acquire voltage information of the battery during flight and information related to a travel mode of the electric flight vehicle; and an output unit configured to output a monitoring result, when a predetermined condition related to an abnormality of the battery is satisfied with reference to the voltage information and a threshold value set for each of travel modes.
When the electric flight vehicle moves vertically, a battery is required to discharge a large current for a certain period of time. That is, during flight, a battery discharge load fluctuates greatly, and a battery voltage also fluctuates greatly. According to the disclosed monitoring device, a threshold value set for each travel mode is used, so that a battery abnormality can be detected early. Thus, safety of flight can be enhanced.
Another aspect of the disclosure is a monitoring method configured to be executed by a processor for monitoring a battery mounted on an electric flight vehicle. The monitoring method comprises: acquiring voltage information of the battery during flight and information related to a travel mode of the electric flight vehicle; and outputting a monitoring result, when a predetermined condition related to an abnormality of the battery is satisfied with reference to the voltage information and a threshold value set for each of travel modes.
When the electric flight vehicle moves vertically, a battery is required to discharge a large current for a certain period of time. That is, during flight, a battery discharge load fluctuates greatly, and a battery voltage also fluctuates greatly. According to the disclosed monitoring method, the threshold value set for each travel mode is used, so that the battery abnormality can be detected early. Thus, safety of flight can be enhanced.
Another aspect of the disclosure is a program stored in a storage medium and configured to be executed by a processor for monitoring a battery mounted on an electric flight vehicle. The program comprising instructions to execute: acquiring voltage information of the battery during flight and information related to a travel mode of the electric flight vehicle; and outputting a monitoring result, when a predetermined condition related to an abnormality of the battery is satisfied with reference to the voltage information and a threshold value set for each of travel modes.
When the electric flight vehicle moves vertically, a battery is required to discharge a large current for a certain period of time. That is, during flight, a battery discharge load fluctuates greatly, and a battery voltage also fluctuates greatly. According to the disclosed program, a threshold value set for each travel mode is used, so that a battery abnormality can be detected early. Thus, safety of flight can be enhanced.
The disclosed aspects in this specification adopt different technical solutions from each other in order to achieve their respective objectives. Reference numerals in parentheses in the claims exemplify the correspondence with portions of embodiments described later, and are not intended to limit the technical scope. The objects, features, and advantages disclosed in this description will become apparent by referring to following detailed descriptions and accompanying drawings.

BRIEF DESCRIPTION OF THE DRAWINGS

FIG. 1 is a diagram a configuration of an eVTOL and a ground station.

FIG. 2 is a diagram showing a functional layout of an operation management system.

FIG. 3 is a plan view showing a battery.

FIG. 4 is a sectional view of the zeroth-order resonant antenna taken along line IV-IV of FIG. 3.

FIG. 5 is a diagram showing a battery cell.

FIG. 6 is a view showing a power profile.

FIG. 7 is a diagram showing detection of an anomaly when a fixed value is used.

FIG. 8 is a diagram showing an example of a monitoring device.

FIG. 9 is a diagram showing another example of the monitoring device.

FIG. 10 is a diagram showing an example of a threshold value stored in a memory.

FIG. 11 is a diagram illustrating an example of the threshold value set by a setting unit.

FIG. 12 is a diagram illustrating another example of the threshold value set by a setting unit.

FIG. 13 is a diagram showing an assembled battery voltage Vb and a cell voltage Vc.

FIG. 14 is a diagram showing an example of threshold value setting when a voltage change rate is used.

FIG. 15 is a diagram showing an example of threshold value setting using a variation in cell voltage.

FIG. 16 is a flowchart showing an example of the control method.

FIG. 17 is a flowchart illustrating another example of the control method.

FIG. 18 is a diagram showing a delay in a fluctuation of the battery voltage due to a normal transient response of the battery voltage.

FIG. 19 is a diagram showing a divergence of the voltage change rate accompanying a normal sudden change in the battery voltage.

FIG. 20 is a flowchart illustrating another example of the control method.

DESCRIPTION OF EMBODIMENTS

Hereinafter, multiple embodiments will be described with reference to the drawings. The same reference numerals are assigned to the corresponding elements in each embodiment, and thus, duplicate descriptions may be omitted. When only a part of the configuration is described in the respective embodiments, the configuration of the other embodiments described before may be applied to other parts of the configuration. Further, it is possible to not only combine configurations as specified in the description of the embodiments but also partially combine configurations of embodiments even though not specified herein as long as the combination does not cause difficulty.

A monitoring device, a monitoring method, and a program described below are applied to an electric flight vehicle. The description of A and/or B means at least one of A and B. That is, the A and/or B can include only A, only B, and both A and B.

First Embodiment:

An electric flight vehicle includes a motor (rotating electrical machine) as a drive source for movement. The electric flight vehicle may be referred to as an electric airplane, an electric aircraft, or the like. The electric flight vehicle can move vertically and horizontally. The electric flight vehicle is capable of moving in a direction that has both vertical and horizontal components, in other words, in an oblique direction. The electric flight vehicle includes, for example, electric vertical takeoff and landing aircraft (eVTOL), electric short takeoff and landing aircraft (eSTOL), drones, etc. The eVTOL is an abbreviation for electric Vertical Take-Off and Landing aircraft. The eSTOL is an abbreviation of an electronic short distance take-off and landing aircraft.

The electric aircraft may be either a manned vehicle or an unmanned vehicle. In the case of a manned aircraft, the electric flight vehicle is operated by a pilot as an operator. In the case of an unmanned vehicle, the electric flight vehicle can be controlled remotely by an operator or automatically by a control system. As an example, the electric flight vehicle in this embodiment is an eVTOL.

<eVTOL>

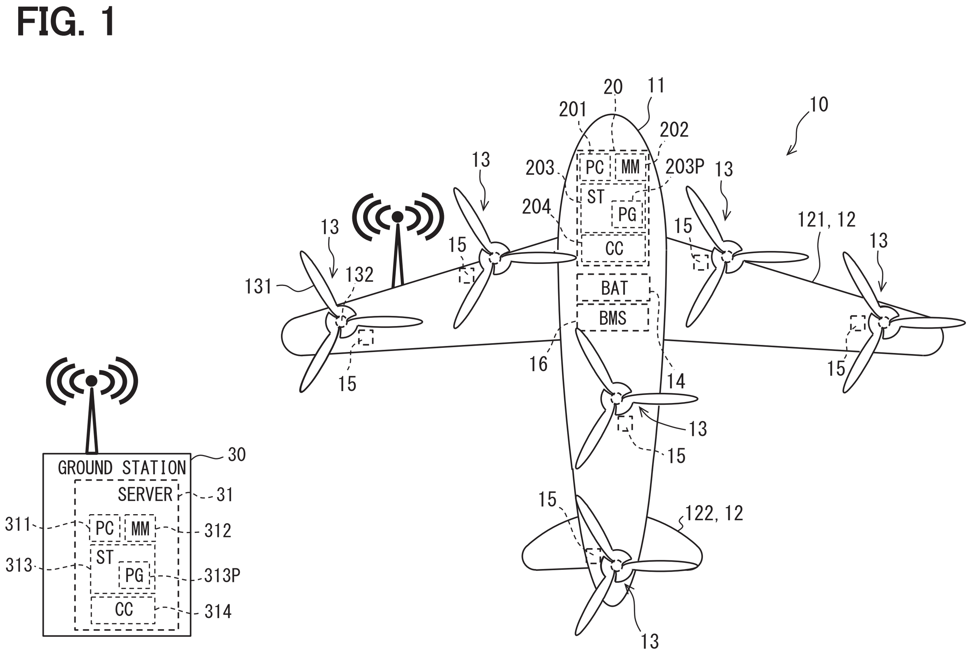

FIG. 1 shows the eVTOL and a ground station. As shown in FIG. 1, a eVTOL 10 includes an airframe main body 11, fixed wings 12, rotary wings 13, a battery 14, EPUs 15 and BMS 16.

The airframe main body 11 is a body portion of an airframe. The airframe main body 11 extends in a front-rear direction. The airframe main body 11 includes an occupant compartment for carrying occupants and/or a luggage compartment in which luggage is loaded.

Each of the fixed wings 12 is a wing portion of the airframe and is continuous to the airframe main body 11. The fixed wings 12 provide the gliding lift. The gliding lift is the lift generated by the fixed wings 12. The fixed wings 12 may include a main wing 121 and a tail wing 122. The main wing 121 extends to the left and right from in the vicinity of the center of the airframe main body 11 along the front-rear direction. The tail wing 122 extends in the left-right direction from a rear portion of the airframe main body 11. A shape of the fixed wing 12 is not particularly limited. For example, a swept-back wing, a delta wing, a straight wing, and the like may be used.

Multiple rotary wings 13 are provided in the airframe. At least a part of the multiple rotary wings 13 may be provided on the fixed wing 12. At least a part of the multiple rotary wings 13 may be provided on the airframe main body 11. The number of the rotary wings 13 provided on the eVTOL 10 is not particularly limited. Multiple rotary wings 13 may be provided on both the airframe main body 11 and the main wing 121.

Each of the rotary wings 13 may be referred to as a rotor, a propeller, a fan, or the like. The rotary wings 13 each have blades 131 and a shaft 132. The blades 131 are attached to the shaft 132. The blades 131 are vanes that rotate together with the shaft 132. Multiple blades 131 extend radially around the axis of the shaft 132. The shaft 132 is a rotation axis of a rotary wing 13 and is rotated by a motor of an EPU 15.

The rotary wings 13 generate a propulsive force by rotation. The thrust primarily acts as rotational lift on the eVTOL 10 during takeoff and landing operations. The rotary wings 13 primarily provide rotational lift during takeoff and landing operations. The rotational lift is the lift generated by the rotation of the rotary wings 13. During takeoff and landing operations, the rotary wings 13 may provide only rotational lift, or may provide both rotational lift and forward thrust. The rotary wing 13 provides the rotational lift when the eVTOL 10 hovers.

The thrust primarily acts as propulsive force on the eVTOL 10 during cruising operations. The rotary wings 13 primarily provide thrust during cruising operations. During cruising operations, the rotary wings 13 may provide only thrust or may provide both lift and thrust.

The battery (BAT) 14 is a device for driving the rotary wings 13. The battery 14 is sometimes referred to as a battery pack. The battery 14 is capable of storing direct current power and includes chargeable battery cells. The battery 14 includes at least one assembled battery having multiple battery cells. The battery cell is a secondary battery that generates an electromotive voltage by a chemical reaction. Each battery cell is, for example, a lithium ion secondary battery, a nickel-metal hydride secondary battery, or the like. Each battery cell may be a secondary battery in which an electrolyte is a liquid, or may be what is called an all-solid-state battery in which an electrolyte is a solid. Each battery cell may have any configuration as long as the battery reaction occurs by ions (electrolyte) contributing to the battery reaction moving between positive and negative electrodes via an electrolytic solution and/or a solid electrolyte. The eVTOL 10 may include a fuel cell and a generator in addition to the battery 14 as a power source that supplies power to the equipment. The battery 14 supplies electric power to the EPUs 15. The battery 14 may supply power to auxiliary machinery (not shown) such as an air conditioner, an ECU 20 (described later), a lift adjustment mechanism (not shown), and the like.

The battery 14 of the eVTOL 10 is required to have high capacity and high output performance. For this reason, battery cells that can obtain high capacity and high output are preferable. In terms of output, battery cells having low resistance in a wide SOC region are preferable. In particular, battery cells having low resistance and high output even in a low SOC region are preferable. The SOC is an abbreviation of a state of charge.

A positive electrode material for the battery cells may be, for example, LCO, NMC, NCA, LFP, or LMFP. LCO is lithium cobalt oxide ($LiCoO_2$). NMC is a lithium nickel cobalt manganese oxide ($Li(NiMnCo)O_2$). NCA is lithium nickel cobalt aluminate ($Li(NiCoAl)O_2$). LFP is lithium iron phosphate ($LiFePO_4$). LMFP is lithium manganese iron phosphate ($LiFe_xMn_yPO_4$). LCO, NMC, and NCA are layered compounds. In particular, a positive electrode of LMFP or a cathode obtained by blending LMFP and NMC, which have low resistance in the low SOC region is preferable.

A negative electrode material for the battery cells may be, for example, a carbon-based material such as hard carbon or soft carbon, a silicon-based material, a lithium-based material, or a titanium-based material such as LTO or NTO. LTO is lithium titanate ($Li_4Ti_{15}O_{12}$). NTO is niobium titanium oxide ($TiNb_2O_7$). In particular, a negative electrode of a carbon material or a negative electrode of a titanium material, which has low resistance in the low SOC region is preferable.

The EPUs 15 rotate and drive the rotary wings 13 that provide thrust to the eVTOL 10. The EPUs 15 are equipment for rotationally driving the rotary wings 13. EPU is an abbreviation for Electric Propulsion Unit. Each EPU 15 corresponds to an electric propulsion device. Each EPU 15 is equipped with a motor. Each EPU 15 may include an inverter and an ESC in addition to the motor. ESC is an abbreviation for Electronic Speed Controller. The number of the EPUs 15 may be the same as the number of the rotary wings 13. For example, the eVTOL 10 may include six EPUs 15. The EPU 15 and the rotary wing 13 are connected in a one-to-one relationship. Alternatively, two or more rotary wings 13 may be connected to a single EPU 15 via a gear box.

The BMS 16 monitors the state of the unit batteries that constitute the battery 14. BMS is an abbreviation for Battery Management System. The BMS 16 is capable of monitoring the voltage, current, temperature, internal resistance, SOC, SOH, and other safety-related states of the battery 14, such as the internal pressure and gas leakage. The SOH is an abbreviation of a state of health. The BMS 16 may be provided integrally with the battery 14. The BMS 16 may be provided separately from the battery 14. A part of the BMS 16 may be provided inside the battery 14 and another part may be provided outside the battery 14.

The BMS 16 may be provided for each assembled battery. One BMS 16 may be provided for multiple assembled batteries. One BMS 16 may be provided for all the assembled batteries. When there are multiple BMSs 16, a function for controlling all the BMSs 16 may be provided separately from the BMS 16 or may be provided integrally with the BMS 16.

The eVTOL 10 further includes the ECU 20 and an auxiliary machine (not shown). ECU is an abbreviation for Electronic Control Unit. The eVTOL 10 may include a lift adjustment mechanism (not shown). The lift adjustment mechanism adjusts the gliding lift of the fixed wings 12. The lift adjustment mechanism increases or decreases the gliding lift generated by the fixed wings 12. The eVTOL 10 may be equipped with, for example, a tilt mechanism or flaps as the lift adjustment mechanism. The tilt mechanism is driven to adjust the tilt angle of the rotary wings 13. The flaps are movable wing pieces and provided on the fixed wings 12.

\<Operation Management System\>

The operation management system is a system for creating an operation plan, monitoring an operation status, collecting and managing information related to an operation, supporting the operation, and the like. At least a part of functions of the operation management system may be arranged in an internal computer of the eVTOL 10. At least a part of the functions of the operation management system may be arranged in an external computer that can wirelessly communicate with the eVTOL 10. The external computer may be a server 31 in a ground station 30 as shown in FIG. 1. The ground station 30 can wirelessly communicate with the eVTOL 10. The ground station 30 can wirelessly communicate with other ground stations.

As an example, in the present embodiment, a part of the functions of the operation management system is arranged in the ECU 20 of the eVTOL 10, and a part of the functions of the operation management system is provided in the server 31 of the ground station 30. The functions of the operation management system are shared between the ECU 20 and the server 31.

As shown in FIG. 1, the ECU 20 includes a processor (PC) 201, a memory (MM) 202, a storage (ST) 203, and a communication circuit (CC) 204 for wireless communication. The processor 201 executes various processes by accessing the memory 202. The memory 202 is a rewritable volatile storage medium. The memory 202 is, for example, a RAM. The RAM is an abbreviation of a random access memory. The storage 203 is a rewritable nonvolatile storage medium. The storage 203 stores a program (PG) 203P to be executed by the processor 201. The program 203P constructs multiple functional units by causing the processor 201 to execute multiple instructions. The ECU 20 may include multiple processors 201.

Similar to the ECU 20, the server 31 includes a processor (PC) 311, a memory (MM) 312, a storage (ST) 313, and a communication circuit (CC) 314. The processor 311 executes various processes by accessing the memory 312. The memory 312 is a rewritable volatile storage medium, for example, a RAM. The storage 313 is a rewritable nonvolatile storage medium. The storage 313 stores a program (PG) 313P to be executed by the processor 311. The program 313P constructs multiple functional units by causing the processor 311 to execute multiple instructions. The server 31 may include multiple processors 311.

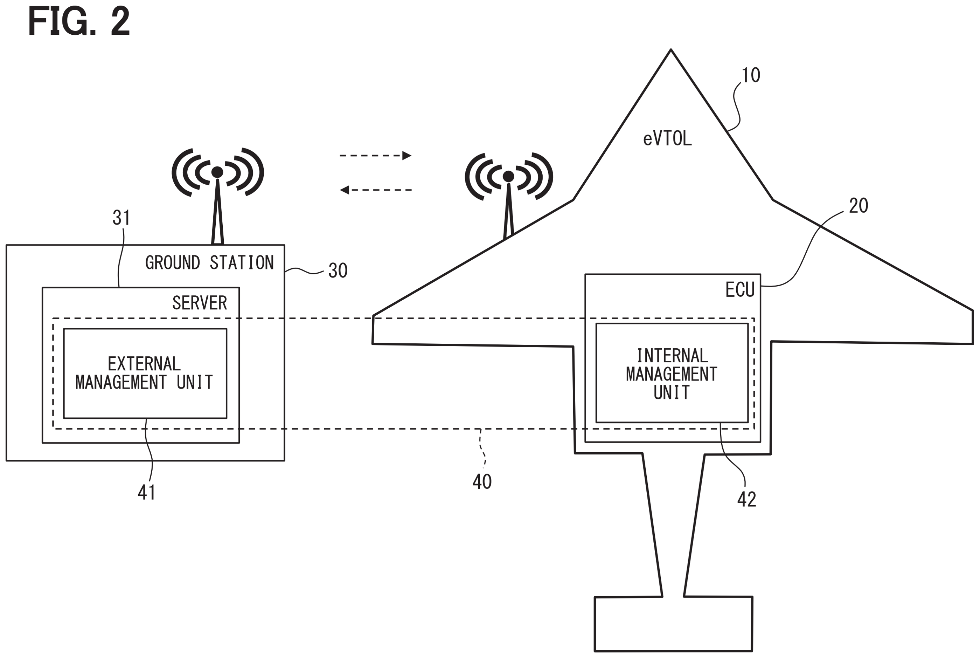

FIG. 2 shows a functional arrangement of the operation management system. A operation management system 40 shown in FIG. 2 includes an external management unit 41 and an internal management unit 42. The external management unit 41 is functionally disposed in the server 31 of the ground station 30. The internal management unit 42 is functionally disposed in the ECU 20 of the eVTOL 10. In this way, a part of the functions of the operation management system 40 may be provided in the server 31, and the other part of the functions may be arranged in the ECU 20. The external management unit 41 and the internal management unit 42 can wirelessly communicate with each other. The internal management unit 42 can communicate with various devices arranged in the eVTOL 10 in a wired or wireless manner.

<Battery>

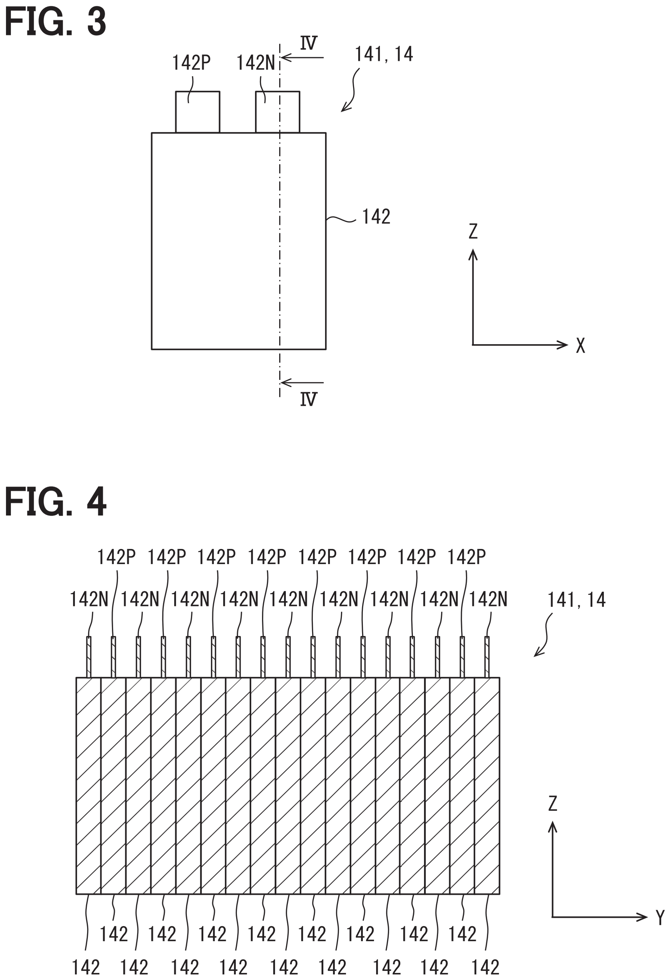

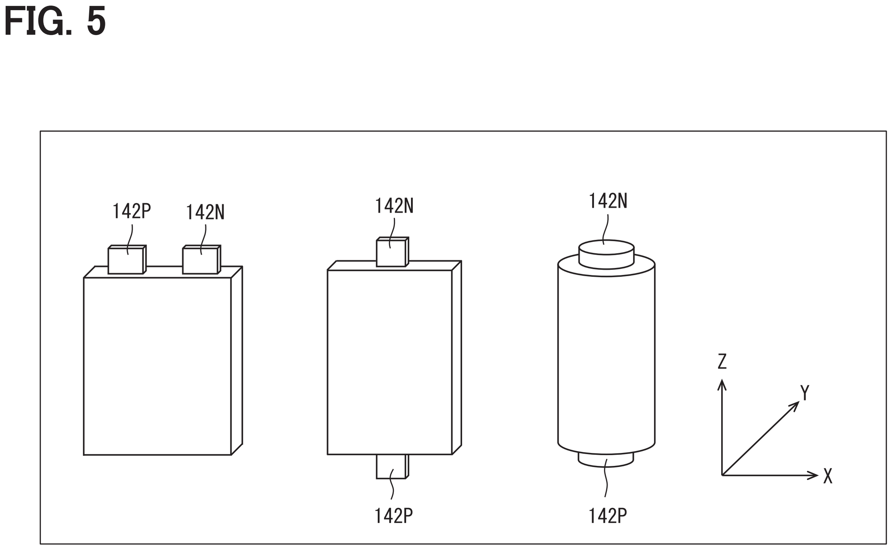

FIG. 3 shows an example of the battery 14. FIG. 4 is a cross-sectional view taken along a line IV-IV in FIG. 3. FIG. 4 illustrates a simplified configuration of the battery cells. FIG. 5 is a diagram showing an arrangement of electrode terminals. In the following, a height direction of each battery cell is referred to as a Z direction, a direction perpendicular to the Z direction is referred to as a Y direction, and a direction perpendicular to both the Z direction and the Y direction is referred to as an X direction. In FIG. 4, for the sake of convenience, the entirety of the battery cells is shown with a metal hatching.

As shown in FIGS. 3 and 4, the battery 14 includes at least one assembled battery 141. The assembled battery 141 includes multiple battery cells 142. The multiple battery cells 142 may have a common structure, or some of the multiple battery cells 142 may have a structure that is different from the other of the multiple battery cells 142. The number and arrangement of the battery cells 142 are not particularly limited. The multiple battery cells 142 may be connected in series, or in combination of series connection and parallel connection.

Each battery cell 142 includes a power generating element and a battery case that accommodates the power generating element. The battery case is an outer casing for the battery cell 142. The battery case may be formed, for example, using a metal material or a laminate film. The shape of the battery cell 142, i.e., the battery case, is not particularly limited. It may be of a rectangular shape, a laminated type, or a cylindrical shape.

Each battery cell 142 includes electrode terminals 142P and 142N. As shown in FIG. 5, the electrode terminals 142P and 142N may be provided on a common surface, or on different surfaces. For example, they may be provided on one surface and on a surface opposite to the one surface. The electrode terminals 142P and 142N may protrude from the corresponding surfaces. The electrode terminal 142P is electrically connected to a positive electrode of the battery cell 142. The electrode terminal 142P may be referred to as a positive electrode terminal or a P terminal. The electrode terminal 142N is electrically connected to the negative electrode of the battery cell 142. The electrode terminal 142N may be referred to as a negative electrode terminal or an N terminal. The electrode terminal may be referred to as a battery cell terminal, a current collecting tab, or the like.

The battery cell 142 shown in FIGS. 3 and 4 has a rectangular shape, specifically, a flat shape that is thin in the Y direction. The multiple battery cells 142 are arranged side by side in the X direction. The electrode terminals 142P and 142N are provided on one of end faces in the Z direction, that is, on a common surface. The multiple battery cells 142 are arranged such that the electrode terminals 142P and the electrode terminals 142N are positioned alternately in the Y direction. In the adjacent battery cells 142, the electrode terminals 142P and the electrode terminals 142N are electrically connected to each other by a bus bar (not shown).

The assembled battery 141 may include multiple battery cells 142 arranged in the Y direction. The arrangement of the battery cells 142 is not limited to the above arrangement. For example, in the case of the cylindrical battery cells 142, the battery cells 142 may be arranged in a staggered pattern when viewed in a plan view in the Z direction.

<Power Profile>

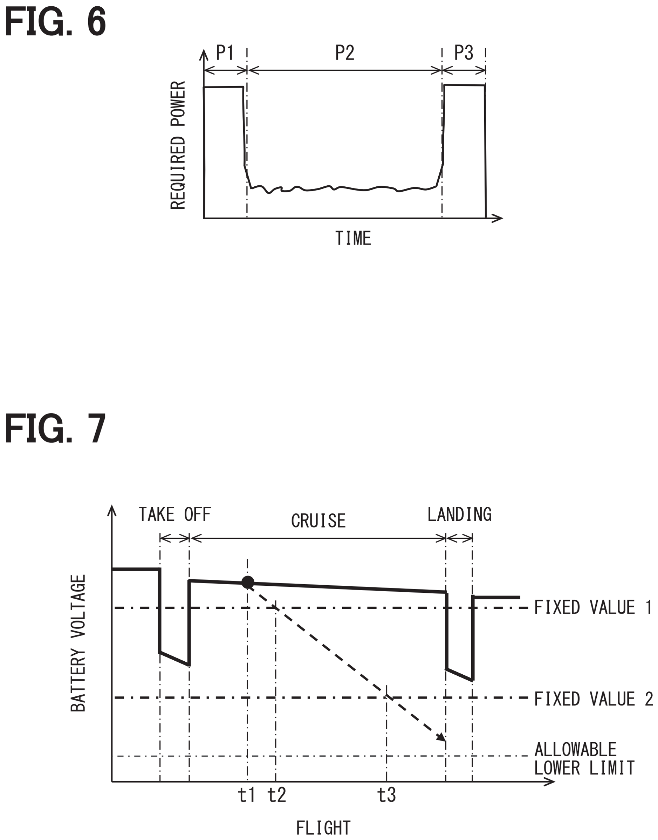

FIG. 6 shows a power profile from take-off to landing of the eVTOL 10. A power profile of an electric flight vehicle other than the eVTOL 10 is similar to that of the eVTOL 10. A period P1 is referred to as a takeoff time, a takeoff flight time, a takeoff operation time, or the like. A period P2 is referred to as a cruising time, a cruising flight time, a cruising operation time, or the like. A period P3 is referred to as a landing time, a landing flight time, a landing operation time, or the like. The periods P1 and P3 are referred to as a takeoff and landing time, a takeoff and landing flight time, a takeoff and landing operation time, or the like. For convenience, in FIG. 6, required power, that is, an output is constant in substantially an entire region of each of the periods P1 and P3.

The eVTOL 10 ascends from a take-off point to a cruising start point in the period P1. The eVTOL 10 cruises at a predetermined altitude in the period P2. The eVTOL 10 descends from an end point of the period P2 to a landing point in the period P3. A movement of the eVTOL 10 mainly includes a horizontal direction component in the period P2 and mainly includes a vertical direction component in each of the periods P1 and P3. During the periods P1 and P3 when moving in the vertical direction, the operation of the rotary wings 13 requires high output continuously for a predetermined time.

Thus, a high output load is applied to the battery 14 during the vertical movement. The more power is required during the takeoff and landing. The output of the battery 14 varies greatly between when it moves vertically and when it moves horizontally. The output of the battery 14 varies greatly between the takeoff and landing and the cruising.

<Battery voltage>

FIG. 7 is a diagram showing detection of an anomaly when a fixed threshold value is used. In FIG. 7, change in battery voltage during flight is shown by a solid line.

As described above, the battery 14 that drives the EPU 15 is required to discharge a large current for a certain period of time during the vertical movement, particularly during the takeoff and landing. For example, during the takeoff and landing, the battery 14 discharges continuously (continually) at a maximum discharge rate of about 3 C to about 15 C for about 30 seconds to about 90 seconds.

The discharge rate indicates a ratio of the current during discharge relative to the battery capacity, and is expressed in the unit of C. A discharge rate of 1C indicates a current value at which a cell having a nominal capacity value is discharged at a constant current until the discharge is completed in one hour. The maximum discharge rate for an electric flight vehicle during cruising and an electric vehicle (BEV) is about 1C to 2C. In the case of a BEV, this is a level where the maximum discharge rate continues for about 5 to 10 seconds. BEV is an abbreviation for Battery Electric Vehicle. Thus, there is a large variation in the discharge characteristic between the takeoff and landing and the cruising.

Monitoring the battery voltage, which reacts sensitively to internal short circuit and sudden deterioration that can cause thermal runaway in the battery 14, is used as a method for early detection of an abnormality. However, during flight, a discharge load of the battery 14 fluctuates greatly, and as shown by the solid line in FIG. 7, the battery voltage also fluctuates greatly. For this reason, it is difficult to detect an abnormality early by management using a fixed value (constant value) as the threshold value.

For example, if an abnormality occurs at time t1 during cruising and the voltage drops as indicated by the dashed arrow, the abnormality can be detected at time t2 by using a relatively high fixed value 1. Although an abnormality can be detected early in this way, the fixed value 1 is high, so an erroneous judgment is made during takeoff and landing. On the other hand, by using a fixed value 2, which is lower than the fixed value 1 and higher than an allowable lower limit of the battery 14, it is possible to avoid an erroneous determination during takeoff and landing. However, the abnormality is detected at time t3, which is later than the time t2. In other words, an abnormality cannot be detected early.

<Monitoring Device>

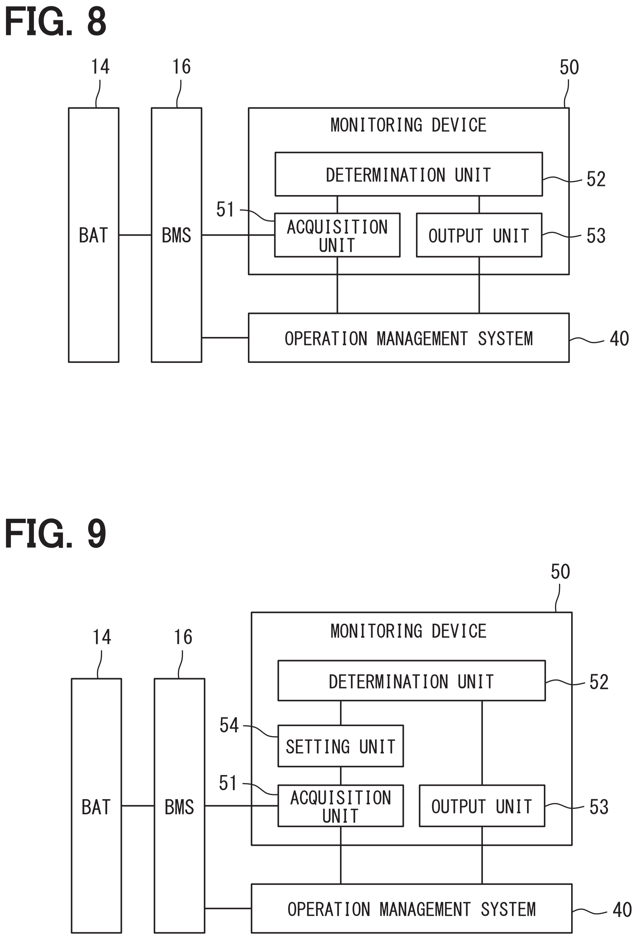

FIG. 8 shows an example of a monitoring device. FIG. 9 shows another example of the monitoring device. As shown in FIG. 8, a monitoring device 50 may include an acquisition unit 51, a determination unit 52, and an output unit 53. As shown in FIG. 9, the monitoring device 50 may further include a setting unit 54.

The monitoring device 50 monitors the battery 14. A functional arrangement of the monitoring device 50 is not particularly limited. At least a part of the functions of the monitoring device 50 may be located inside the flight vehicle or outside the flight vehicle. The functions of the monitoring device 50 may be distributed across multiple devices inside the flight vehicle. The functions of the monitoring device 50 may be distributed across multiple devices outside the flight vehicle. A part of the functions of the monitoring device 50 may be located inside the flight vehicle, and another part of the functions may be located outside the flight vehicle.

For example, at least a part of the functions of the monitoring device 50 may be located in the BMS 16. At least a part of the functions of the monitoring device 50 may be arranged in the ECU 20. At least a part of the functions of the monitoring device 50 may be arranged in the server 31 of the ground station 30. At least a part of the functions of the monitoring device 50 may be arranged in the operation management system 40. At least a part of the functions of the monitoring device 50 may be arranged in the internal management unit 42. At least a part of the functions of the monitoring device 50 may be arranged in the external management unit 41.

The acquisition unit 51 acquires information on the voltage of the battery 14 during flight and information related to the travel mode of the eVTOL 10. The information on the voltage of the battery 14 during flight may be referred to as battery voltage information or voltage information. The information related to the travel mode may be referred to as travel mode information.

The acquisition unit 51 may acquire information such as the voltage information and the travel mode information from the BMS 16, the operation management system 40, the EPU 15, and the like. The acquisition unit 51 may acquire, as the information, an actual measurement value, an intermediate calculated value, and a calculated value such as a feature quantity. The information may be acquired by performing calculation within the monitoring device 50 based on the actual measurement and the intermediate calculated value acquired from the BMS 16 and the like. The acquisition unit 51 acquires information through wireless communication and/or wired communication.

For example, the resistance of the battery 14 changes depending on the ambient temperature. The battery voltage is affected by variations in the battery resistance. In other words, the battery voltage is affected by the environmental temperature and the like. Therefore, the acquisition unit 51 may acquire the environmental information in addition to the voltage information and the travel mode information. For example, a temperature, a wind speed, a wind direction, and the like may be acquired as the environmental information. Therefore, by taking a fluctuation in these environmental parameters into consideration, it is possible to improve the accuracy of the abnormality determination.

The eVTOL 10 may take multiple travel modes during flight. The travel mode may include a mode in which the vehicle moves mainly in the vertical direction and a mode in which the vehicle moves mainly in the horizontal direction. In addition to the vertical travel mode and the horizontal travel mode, a diagonal travel mode may also be included. The eVTOL 10 moves primarily vertically during takeoff and landing, and primarily horizontally during cruise. Thus, the mobility mode may include a takeoff and landing mode and a cruise mode. The mobility modes may include the takeoff mode, the cruise mode, and the landing mode. The cruise mode may be subdivided by taking into account the case where the vehicle temporarily moves vertically during cruising.

The acquisition unit 51 may acquire, as the travel mode information, information indicating the travel mode itself, or information for determining the travel mode. The acquisition unit 51 may acquire discharge characteristic information and/or flight information as the travel mode information. The acquisition unit 51 may have a function of determining the travel mode based on the acquired discharge characteristic information and/or the flight information. The monitoring device 50 may include a functional unit that determines the travel mode based on the information acquired by the acquisition unit 51, separately from the acquisition unit 51. The discharge characteristic information is information relating to the discharge current. For example, when the discharge current is equal to or greater than a predetermined threshold value, it may be determined to be the vertical travel mode, and when it is less than the threshold value, it may be determined to be the horizontal travel mode.

The flight information may be a signal indicating the travel mode obtained from the operation management system 40 or the like. The flight information may be altitude change information such as an ascent rate or a descent rate of the eVTOL 10. For example, when the ascent rate is equal to or greater than a predetermined threshold value, it may be determined to be the vertical travel mode, and when it is less than the threshold value, it may be determined to be the horizontal travel mode. The flight information may be information indicating the orientation of the rotary wing 13. In a case of a configuration in which the orientation of the rotary wing 13 can be changed depending on the travel mode by a tilt mechanism or the like, the travel mode can be determined from information on the orientation of the rotary wing 13. The flight information may be time information in the flight. When time of the operation is precisely managed, the travel mode may be determined by the time. In a case of repeated spot-to-spot movement, the time of the operation is precisely managed. In particular, in a case of an automated operation, the time of the operation is managed more precisely.

The acquisition unit 51 may acquire information on the battery state together with the discharge characteristic information, as the travel mode information. The battery state information is an open circuit voltage (OCV) and/or the resistance. OCV is an abbreviation for Open Circuit Voltage. Instead of the OCV, the SOC may be acquired. The SOC is an abbreviation of a state of charge.

The determination unit 52 has a function of comparing the voltage information acquired by the acquisition unit 51 with a threshold value set for each travel mode, and determining whether there is a battery abnormality. The threshold value may be set to a different value for each travel mode. The determination unit 52 functions as a detection unit that detects a battery abnormality. The determination unit 52 may have a function of determining whether abnormality detection is being performed normally based on the voltage information. The determination unit 52 may function as a diagnosis unit that diagnoses (determines) whether the abnormality detection function is normal. The monitoring device 50 may include a diagnosis unit separately from the determination unit 52. The monitoring device 50 may include a diagnostic unit separately from the detection unit. The determination unit 52 may include a function of detecting an abnormality or limiting a threshold value for a predetermined period of time. The determination unit 52 may function as a limiting unit that detects an anomaly or limits a threshold value. The monitoring device 50 may include a limiting unit separately from the determination unit 52 (detection unit).

The output unit 53 outputs the determination result of an abnormality to an outside of the monitoring device 50. The output unit 53 outputs a monitoring result when a predetermined condition of an abnormality in the battery 14 is satisfied. The output unit 53 may output the determination result, for example, issue an alarm to a crew or the ground station 30. The output unit 53 may output the determination result to trigger a transition to the avoidance operation. The output unit 53 may output the determination result to the operation management system 40 that displays an operational status of the flight vehicle and controls the operation. The monitoring device 50 itself may implement the display. The output unit 53 may output a control request for the avoidance operation to a control device that controls the flight. The control device may be provided integrally as one function of the operation management system 40, or may be provided separately.

The output unit 53 may implement the output in multiple stages, for example, may issue the warning in a first stage and may perform the avoidance operation in a second stage or later. As the avoidance operation, for example, redundant operation of the battery 14 may be implemented, or an emergency landing operation may be implemented. The redundant operation of the battery 14 may, for example, stop output of a system that causes an abnormality and continue the flight using the remaining system. As the avoidance action, multiple actions may be implemented simultaneously. The avoidance action may be a step-by-step action. The output unit 53 may estimate a time period until an abnormality occurs based on a time series transition of the target information, and output the estimated time period as urgency information.

The setting unit 54 sets a threshold value for comparison with the voltage information based on the travel mode information acquired by the acquisition unit 51. The setting unit 54 sets the threshold value for each travel mode. The threshold value may be set to a different value for each travel mode. The setting unit 54 may set the threshold value based on the discharge characteristic information and the battery state information, which are the travel mode information.

<Threshold value>

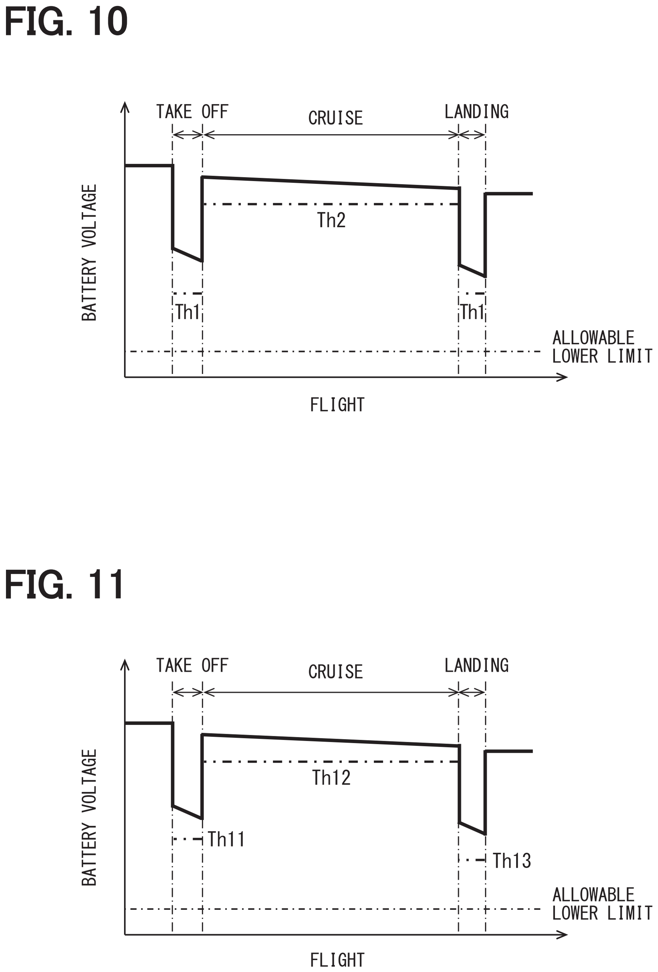

The threshold value is set individually for each travel mode. The threshold value is set depending on the travel mode. The threshold value may be associated with the travel mode and stored in advance in memory. The determination unit 52 reads out the threshold value corresponding to the travel mode from the memory and uses the threshold value for determination. FIG. 10 shows an example of the threshold value stored in the memory. The travel mode includes two types: the takeoff and landing mode and the cruise mode. The memory stores a threshold value Th1 corresponding to the takeoff and landing mode and a threshold value Th2 corresponding to the cruise mode. The determination unit 52 makes a determination using the threshold value Th1 in the takeoff and landing mode, and makes a determination using the threshold value Th2 in the cruise mode. The threshold value Th1 is set to a value lower than the threshold value Th2 and higher than an allowable lower limit.

The threshold value may be set with a predetermined margin of error relative to the voltage behavior during flight, for example, by deriving a normal voltage behavior in flight by implementing a prior experiment or battery simulation. The margin is a margin for, for example, a variation in the battery discharge characteristic, fluctuations in the OCV or the battery resistance, an error in the detection system, and the like. The threshold value may be prepared for each flight plan, such as for each different flight route.

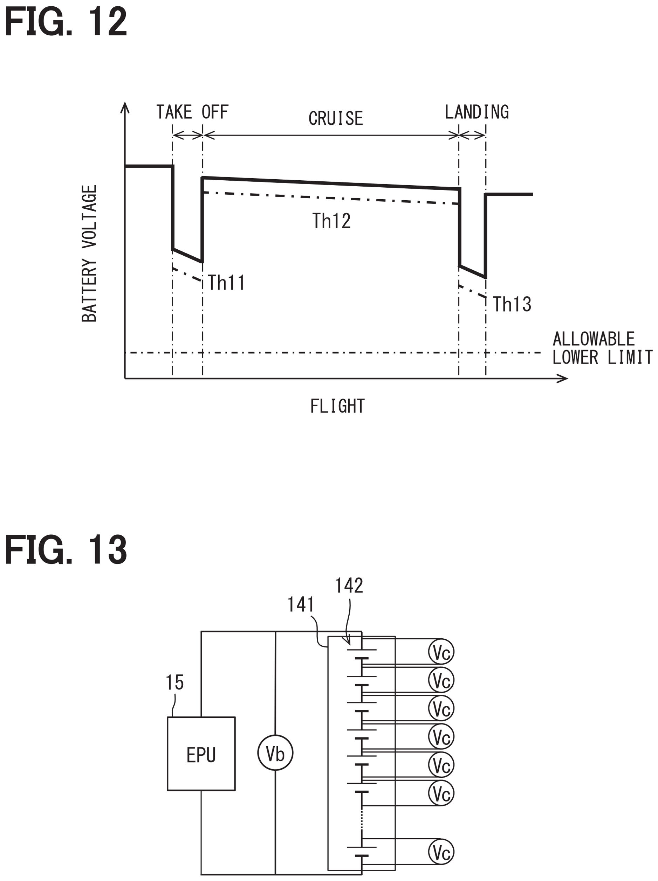

The threshold value may be set by the setting unit 54 depending on the travel mode. The setting unit 54 may set the threshold value based on the discharge characteristic information and battery state information acquired by the acquisition unit 51. FIG. 11 shows an example of the threshold value set by the setting unit 54. FIG. 12 shows another example of the threshold value set by the setting unit 54. In FIGS. 11 and 12, the travel mode includes three types: the takeoff mode, the cruise mode, and the landing mode. The setting unit 54 sets the threshold value Th11 corresponding to the takeoff mode, the threshold value Th12 corresponding to the cruise mode, and the threshold value Th13 corresponding to the landing mode.

The relationship shown in Equation 1 holds between the battery voltage during discharge, the discharge characteristic (discharge current), and the battery state (OCV, battery resistance). Therefore, when the discharge characteristic information and the battery state are reflected in setting of the threshold value, it becomes possible to detect an abnormality earlier and with higher accuracy.

$$\text{Battery voltage during discharge} = \text{OCV} - \text{discharge current} \times \text{battery resistance} \quad \text{(Equation 1)}$$

The OCV decreases as the SOC decreases. An SOC-OCV map may be made in advance, and the OCV may be calculated from the SOC value. During landing, the SOC becomes lower than during takeoff. Therefore, as shown in FIG. 11, the threshold value Th13 may be set at the time of landing to be lower than the threshold value Th11 set at the time of takeoff.

The resistance of the battery 14 also changes with the SOC. The behavior of the resistance may be determined in advance through an experiment or the like, and then may be calculated using a map model or a regression model. Many of the battery cells 142 tend to have an increased resistance in a low SOC region. The setting unit 54 may reflect the resistance in setting of the threshold value, particularly in flight using the low SOC region.

The setting unit 54 may set the threshold value using information updated before flight by battery state diagnosis performed when the aircraft is parked between flights. The battery state diagnosis may include AC impedance diagnosis. It is possible to obtain a parameter of a battery equivalent circuit model and a battery reaction model, such as a DC resistance, a battery reaction resistance, and a diffusion resistance. This allows for voltage fluctuation during discharge (during flight) to be simulated immediately before flight, resulting in greater accuracy.

The setting unit 54 may successively change the threshold value to be set based on change in the battery state during flight. As shown in FIG. 12, the setting unit 54 may successively change the threshold value in accordance with change in the battery voltage. This enables earlier and more accurate detection of an abnormality. The setting unit 54 may set the threshold value based on a flight plan when the flight plan is made. The setting unit 54 may set the threshold value according to a result during flight. The threshold value based on the plan may be updated depending on an actual result.

The setting unit 54 may use, as the battery state information, information on increase in the resistance caused by concentration imbalance of ion that contributes to battery reaction. When the battery 14 is discharged, temporary imbalance occurs in the concentration distribution of ion that contributes to the battery reaction. The concentration imbalance occurs in the electrolytic solution or the electrode. When the concentration imbalance occurs, the internal resistance of the battery temporarily (reversibly) rises. Therefore, even when the SOC of the battery 14 is sufficient, the output performance of the battery 14 decreases. In this manner, temporary (reversible) deterioration occurs in the battery 14. The temporary deterioration may be called high-rate deterioration.

The greater the concentration imbalance is, the more the degree of temporary deterioration increases. In an electric flight vehicle, especially in the eVTOL, high output is required during takeoff flight and landing flight. Therefore, a degree of temporary deterioration is likely to increase. The setting unit 54 predicts the degree of temporary deterioration and reflects it in the threshold value, thereby enabling earlier and more accurate abnormality detection. The setting unit 54 may predict primary deterioration in advance and reflect this in the threshold value.

The setting unit 54 may acquire information on a degree of temporary deterioration of the battery 14, or may calculate the degree of temporary deterioration based on the acquired information. The degree of temporary deterioration is a difference of the internal resistance from a reference value. The reference value may be an initial internal resistance value before takeoff in the current flight, for example. The reference value may be the value of the internal resistance after processing to eliminate temporary deterioration, or may be the value of the internal resistance after charging on the ground. The reference value is preferably a value of the internal resistance after the temporary deterioration is sufficiently eliminated. The calculation of the degree of temporary deterioration may be an actual measurement calculation based on an actual measured value or a prediction calculation based on a predicted value. The calculation value may be the degree of temporary deterioration at the time point of monitoring, or may be the degree of temporary deterioration at the time point of takeoff or at the time point of landing.

The setting unit 54 may predict the degree of primary deterioration in advance and reflect it in the threshold value. The setting unit 54 may predict the degree of temporary deterioration in advance by calculating a fluctuation profile of the temporary deterioration based on the discharge profile planned for the flight. The setting unit 54 may predict the degree of temporary deterioration based on, for example, a prediction map or a prediction model such as multiple regression. The degree of temporary deterioration may be predicted based on a prediction model generated using machine learning.

The setting unit 54 may use past history data to calculate the fluctuation profile of temporary deterioration, and predict the degree of temporary deterioration in advance. As the history data, information on the degree of past temporary deterioration that matches the takeoff point and/or the landing point and the model of the target flight may be used. Since the navigation schedule of the eVTOL 10 is finite and the repetition frequency is high, the history information can be utilized. Furthermore, since the history information at the takeoff point and the landing point where the prediction error is likely to occur is utilized, the prediction accuracy of the degree of temporary deterioration can be enhanced. Ease of operation, an output characteristic, and the like vary depending on the model (type) of the eVTOL 10. This can further enhance the prediction accuracy of the degree of temporary deterioration.

The setting unit 54 may set the threshold value depending on degree of increase (actual result) in the temporary deterioration during flight. The setting unit 54 may update the threshold value based on prediction according to an actual result. The setting unit 54 may calculate the degree of temporary deterioration based on a history of the output of the battery. The setting unit 54 may calculate an integrated value of the discharge current during flight as the degree of temporary deterioration. When charge is performed, the integrated value of the charge-discharge current may be used as the degree of temporary deterioration. An output stop at the time of standby on the ground or a temporary output stop during flight also acts in a direction of eliminating the concentration imbalance caused by discharge to a considerable extent. Therefore, the current integrated value may be corrected in a direction of eliminating the concentration imbalance.

The larger the current (output) is or the longer duration of the output is, the more likely the concentration imbalance is to occur. Therefore, in a case where the integrated value of the current is used, the value may be integrated while weighting for each current value and/or duration. The weighting coefficient may be calculated using a map or a regression model created in advance from data such as an experiment.

The battery physical model is a model that can model an electrochemical reaction and material transport and analyze the concentration distribution. When the current history is input to this battery physical model to perform calculation, it is possible to estimate a concentration imbalance of ions in an electrolytic solution or an electrode that contributes to the battery reaction.

The setting unit 54 may calculate the degree of temporary deterioration based on the battery resistance. The setting unit 54 may calculate the increase (change) in the internal resistance, that is, the degree of temporary deterioration itself. The change amount is a decrease amount at the time of elimination of the temporary deterioration. The resistance increase amount of the battery 14 can be calculated using a time-series value of the internal resistance calculated from the voltage, the current, and the like of the battery 14.

The setting unit 54 may calculate the degree of temporary deterioration using the resistance estimated by the battery model. The battery model is, for example, a battery equivalent circuit model. The estimated resistance is obtained from an estimated current estimated from the battery model in which the concentration distribution is assumed to be uniform and an actually measured voltage. The degree of temporary deterioration can be calculated from the difference between the estimated resistance and the measured resistance obtained from the actually measured current and the actually measured voltage.

The calculation unit 54 may calculate the degree of temporary deterioration based on the resistance component of the alternating-current impedance of the battery. The increase amount (change amount) of the resistance component of the alternating-current impedance of the battery 14 can be used as the degree of temporary deterioration. In particular, the increase amount of the resistance component in a high frequency region of the alternating-current impedance may be used as the degree of temporary deterioration. The degree of concentration imbalance in the electrolytic solution, which is a main factor of the imbalance, can be calculated more accurately.

The setting unit 54 may calculate the degree of temporary deterioration based on historical information of past flights. As the history information, information on the degree of past temporary deterioration that matches the flight for which the takeoff point and/or the landing point and the model are targets may be used. Since the navigation schedule of the eVTOL 10 is finite and the repetition frequency is high, the history information can be utilized. Furthermore, since the history information at the takeoff point and the landing point where the prediction error is likely to occur is utilized, the prediction accuracy of the degree of temporary deterioration can be enhanced. Ease of operation, an output characteristic, and the like vary depending on the model (type) of the eVTOL 10. This can further enhance the prediction accuracy of the degree of temporary deterioration.

<Voltage information>

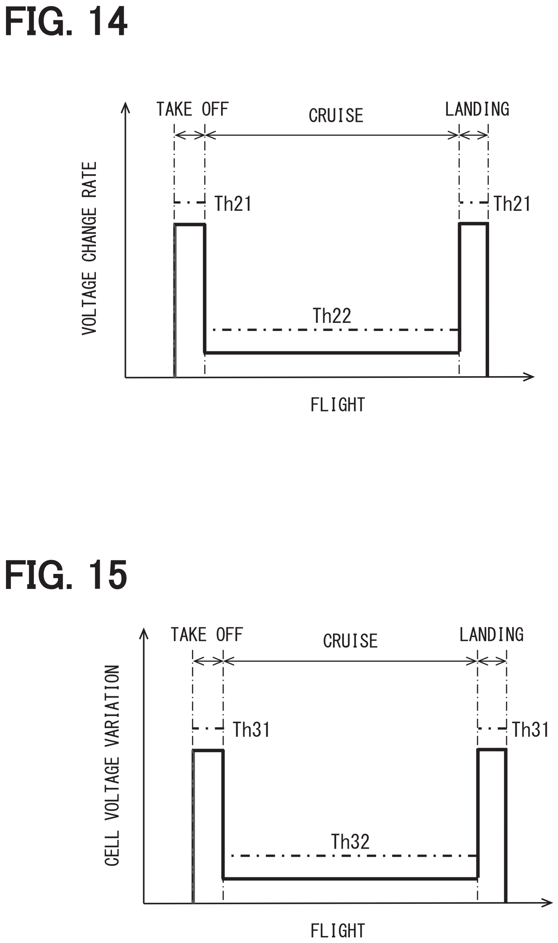

FIG. 13 shows an assembled battery voltage Vb and a cell voltage Vc. FIG. 14 shows an example of threshold value setting when a voltage change rate is used. FIG. 15 shows an example of threshold value setting using a variation in cell voltage. In FIG. 14, the threshold value for the takeoff and landing mode is Th21, and the threshold value for the cruise mode is Th22. In FIG. 15, the threshold value for the takeoff and landing mode is Th31, and the threshold value for the cruise mode is Th32.

As shown in FIG. 7, when the voltage drops due to an abnormality in the battery 14, the absolute value decreases, the voltage change rate increases, and the variation between cells increases. The voltage change rate may also be referred to as a voltage change speed.

The acquisition unit 51 may acquire, as the battery information, an absolute value of the assembled battery voltage Vb shown in FIG. 13. The acquisition unit 51 may acquire an absolute value of each cell voltage Vc. The acquisition unit 51 may acquire the voltage change rate as the battery information as shown in FIG. 14. The voltage change rate may be a change rate of the assembled battery voltage Vb or a change rate of the cell voltage Vc. The acquisition unit 51 may acquire, as the battery information, a variation in the cell voltage Vc as shown in FIG. 15.

The acquisition unit 51 may acquire, as the battery information, at least one of an absolute value of the assembled battery voltage Vb, an absolute value of each cell voltage Vc, the rate of change in the assembled battery voltage Vb, a rate of change in the cell voltage Vc, and a variation in the cell voltage Vc. By monitoring multiple parameters such as the absolute value, the rate of change, and the variation, it becomes possible to detect an abnormality in the battery 14 with higher accuracy.

<Monitoring method>

As described above, the monitoring device 50 may be arranged in the ECU 20 of the eVTOL 10. In this case, execution of processing of each functional block of the monitoring device 50 by the processor 201 corresponds to execution of the monitoring method. The monitoring device may be located at the server 31 of the ground station 30. In this case, execution of processing of each functional block of the monitoring device 50 by the processor 311 corresponds to execution of the monitoring method.

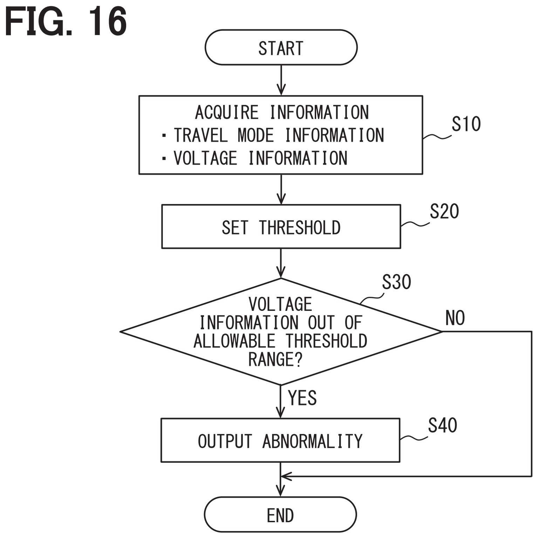

As the monitoring method, for example, a method shown in FIG. 16 may be used. The monitoring device 50 (e.g., the processor 201) repeatedly executes the process shown in FIG. 16 at a predetermined cycle. First, the monitoring device 50 acquires information (step S10). The monitoring device 50 acquires travel mode information and voltage information of the battery 14. The monitoring device 50 may acquire the above-mentioned flight information as the travel mode information. The monitoring device 50 may acquire discharge characteristic information of the battery 14 as the travel mode information. The monitoring device 50 may acquire flight information and discharge characteristic information as the travel mode information. The monitoring device 50 may acquire discharge characteristic information of the battery 14 as the travel mode information. The monitoring device 50 may acquire flight information, discharge characteristic information, and battery state information as the travel mode information.

Next, the monitoring device 50 sets a threshold value for each travel mode (step S20). The monitoring device 50 may read out from memory and set a threshold value according to the travel mode. The monitoring device 50 may set the threshold value by calculation or the like based on the travel mode information. The monitoring device 50 may set the threshold value based on discharge characteristic information and battery state information.

Next, the monitoring device 50 compares the acquired voltage information with a threshold value and determines whether the voltage information is outside an allowable threshold value range (step S30). For example, the monitoring device 50 may determine that the assembled battery voltage Vb is outside the allowable threshold value range when the absolute value of the assembled battery voltage Vb is less than the threshold value, and may determine that the assembled battery voltage Vb is within the allowable threshold value range when the absolute value of the assembled battery voltage Vb is equal to or greater than the threshold value. The monitoring device 50 may determine that the cell voltage Vc is outside the allowable threshold value range when the absolute value of the cell voltage Vc is less than the threshold value, and may determine that the cell voltage Vc is within the allowable threshold value range when the absolute value of the cell voltage Vc is equal to or greater than the threshold value. The monitoring device 50 may determine that the rate of change in the assembled battery voltage Vb is outside the allowable threshold value range when it is greater than the threshold value, and may determine that the rate of change in the assembled battery voltage Vb is within the allowable threshold value range when it is equal to or less than the threshold value. The monitoring device 50 may determine that the rate of change in the cell voltage is outside the allowable threshold value range when it is greater than the threshold value, and may determine that the rate of change in the cell voltage is within the allowable threshold value range when it is equal to or less than the threshold value. The monitoring device 50 may determine that the variation in the cell voltage is outside the allowable threshold value range when it is greater than the threshold value, and may determine that the variation in the cell voltage is within the allowable threshold value range when it is equal to or less than the threshold value.

When the voltage information is outside the allowable threshold value range, the monitoring device 50 determines that there is an abnormality in the battery 14 and outputs existence of an abnormality (step S40), and ends the series of processes. When the voltage information is within the allowable threshold value range, the monitoring device 50 does not execute the process of step S40 and ends the series of processes.

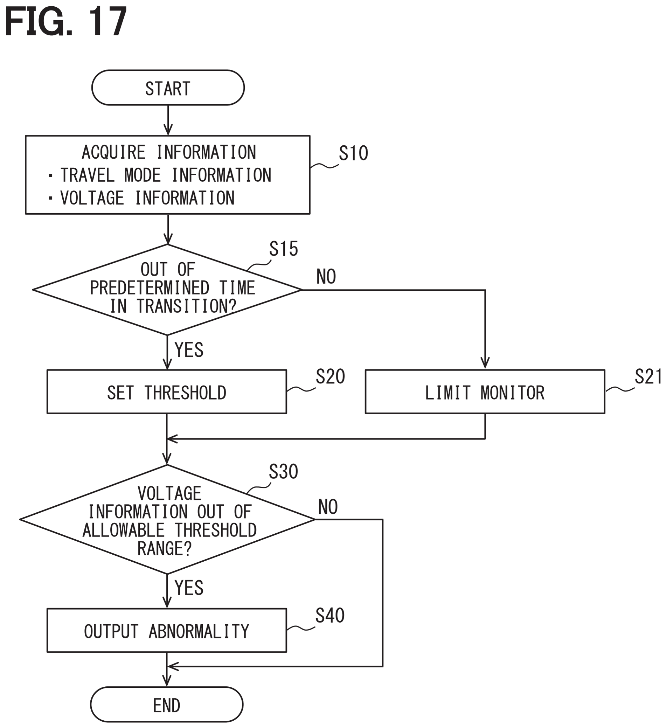

As the monitoring method, a method shown in FIG. 17 may be used. First, the monitoring device 50 executes the process of step S10 in the same manner as in the method shown in FIG. 16. Next, the monitoring device 50 determines whether it is outside a predetermined period at the time of transition (step S15). The monitoring device 50 determines whether the transition between the vertical movement and the horizontal movement is outside of the predetermined period.

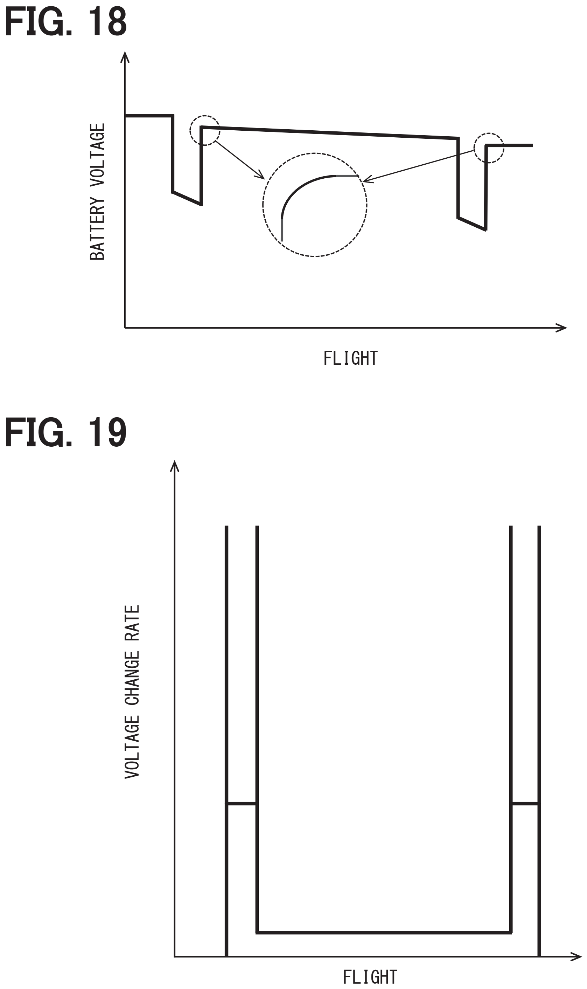

The equivalent circuit of the battery 14 includes a capacitor component connected in parallel with a resistor. Therefore, as shown in FIG. 18, fluctuations in the battery voltage cause a transient response according to the capacitor component. For example, the transient response occurs in switching from the takeoff to the cruise. Furthermore, the battery voltage fluctuates suddenly in the transition between the vertical movement and the horizontal movement. Therefore, as shown in FIG. 19, divergence of the voltage change rate occurs in the transition. Furthermore, delay in signal propagation in the circuit may cause delay in switching of the threshold value.

Thus, in the transition between the vertical movement and the horizontal movement, normal sudden fluctuation in the voltage information, delay in fluctuations in the battery voltage due to normal transient response, and delay in switching of the threshold value may occur. This may result in erroneous determination.

In the example shown in Figure 17, in order to prevent the erroneous determination, it is determined whether it is a timing that corresponds to a timing, at which the sudden voltage fluctuation may occur, a timing, at which the delay in voltage fluctuation may occur, or a timing, at which the delay in switching of the threshold value may occur, i.e., whether it is in the predetermined period in the transition. The predetermined period is at least a part of the period in the transition. The predetermined period may be set, for example, by deriving a normal period of sudden fluctuation in the voltage information in the transition using prior experiments and battery simulations, a delay period of battery voltage fluctuation due to the normal transient response, and a delay period of switching of the threshold value, and by setting based on the derived periods. The derived periods may be set with respective predetermined margins.

When it is determined in step S15 that it is out of the predetermined period, the monitoring device 50 executes the process of step S20 and subsequent steps, similarly to the method shown in FIG. 16. On the other hand, when it is determined that it is not outside the predetermined period, that is, it is within the predetermined period, the monitoring device 50, for example, restricts the monitoring (step S21). The monitoring device 50 excludes the predetermined period from the detection of an abnormality. The monitoring device 50 does not perform the detection of an abnormality based on voltage information in the predetermined period. The restriction of the monitoring may be applied to any of the sudden voltage fluctuation, delay in the voltage fluctuation, and delay in switching of the threshold value.

In step S21, the monitoring device 50 may execute a process of applying the threshold value before the transition instead of restricting the monitoring. For example, the threshold value set in the vertical movement is maintained for the predetermined period in the transition from the vertical movement to the horizontal movement. The application of the threshold value before the transition may be applied to the delay in the voltage fluctuation and the delay in the switching of the threshold value as described above. Instead of restricting the monitoring, the monitoring device 50 may execute a process of applying an upper limit voltage and/or a lower limit voltage allowed for the battery 14 as the threshold value. The application of the allowable upper and/or the lower limit voltage may be applied to the delay in the voltage change and the delay in the switching of the threshold value as described above. In this way, the threshold value may be limited to a predetermined value.

After executing the process of step S21, the monitoring device 50 executes the processes the step S30 and subsequent processes, similarly to the method shown in FIG. 16.

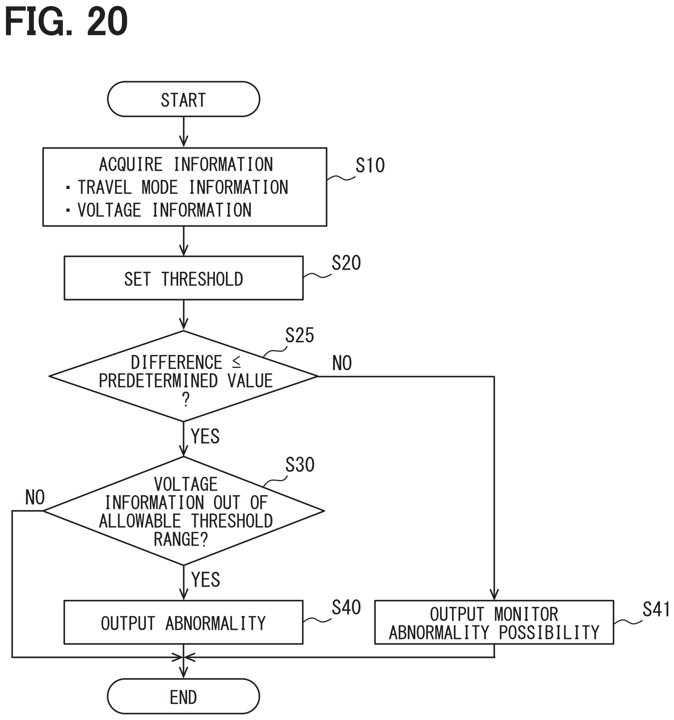

As the monitoring method, a method shown in FIG. 20 may be used. First, the monitoring device 50 executes the process of steps S10 and S20 in the same manner as in the method shown in FIG. 16. Next, the monitoring device 50 determines whether the difference between the assembled battery voltage Vb and the sum of all the cell voltage Vc is equal to or less than a predetermined value (step S25). The monitoring device 50 diagnoses whether detection of an abnormality is being performed normally. The sum of all the cell voltage Vc is a sum of the voltage (cell voltage Vc) of all the battery cells 142 in the assembled battery 141 that generates the assembled battery voltage Vb. The predetermined value may be set based on difference between the normal assembled battery voltage Vb during flight and the sum of all the cell voltage Vc, that is derived by using a prior experiment or battery simulation. The derived difference may be set with a predetermined margin.

When it is determined in step S25 that the difference is within the predetermined value, the monitoring device 50 executes the process of step S30 and subsequent processes, similarly to the method shown in FIG. 16. On the other hand, when it is determined that the difference is not equal to or less than the predetermined value, that is, that the difference is greater than the predetermined value, the monitoring device 50 outputs a message indicating that possibility of a monitoring abnormality arises (step S41), and ends the series of processes. When the difference is not equal to or less than the predetermined value, the monitoring device 50 does not execute the processes of steps S30 and S40, that is, does not execute detection of an abnormality, and ends the series of processes.

In the method shown in FIG. 16, when the battery information is within the allowable threshold value range, the monitoring device 50 may output that there is no abnormality, and then end the series of processes. The same applies to the method shown in FIG. 17 and the method shown in FIG. 20.

The determination unit 52 (detection unit) of the monitoring device 50 may execute the process of step S15 and the process of step S21 shown in FIG. 17. A functional unit other than the determination unit 52 may execute at least one of the process of step S15 and the process of step S21.

Summary of First Embodiment:

As described above, when the eVTOL 10 (electric flying vehicle) moves in the vertical direction, the battery 14 is required to discharge a large current for a certain period of time. Monitoring the battery voltage, which reacts sensitively to internal short circuit and sudden deterioration that can cause thermal runaway in the battery 14, is used as a method for early detection of an abnormality. That is, during flight, a discharge load fluctuates greatly, and a battery voltage also fluctuates greatly. For this reason, it is difficult to detect an abnormality early by management using a fixed value (constant value) as the threshold value.

The monitoring device 50 of this embodiment acquires information about the travel mode along with the voltage information of the battery 14, and monitors the voltage information using the threshold value set for each travel mode. Therefore, an abnormality in the battery 14 can be detected early. Thus, safety of flight can be enhanced.

The monitoring device 50 may be applied to a configuration in which the maximum discharge rate of the battery 14 during the vertical movement of the eVTOL 10 to the maximum discharge rate during the horizontal movement is 1.5 times or more. The monitoring device 50 may be applied to a configuration in which the discharge rate during the vertical movement is 3C or more.

As described above, an electric flight vehicle such as the eVTOL 10 have a large fluctuations in the discharge characteristic. The greater the fluctuation in the discharge characteristics, the more effective the early detection by the monitoring device 50 becomes. For example, when the ratio of the maximum discharge rate during the movement in the vertical direction to the maximum discharge rate during the movement in the horizontal direction is 1.5 or more, the effect of early detection is enhanced. When the ratio is even higher, for example, 2 times or more, 3 times or more, or 5 times or more, a greater effect can be achieved. The higher the discharge rate during the vertical movement, the more effective the monitoring device 50 is in early detection. When the discharge rate is 3C or more, the effect of early detection is enhanced. When the discharge rate is even higher, for example, 5C or more, 7C or more, or 10C or more, a greater effect can be achieved.

The monitoring device 50 may acquire, as information related to the travel mode, battery discharge characteristic information and/or flight information. By using the above information, the threshold value can be switched at an appropriate timing according to the travel mode.

The monitoring device 50 sets the threshold value for each travel mode based on the discharge characteristic information and the battery state information, which are information related to the travel mode. As shown in Equation 1, the predetermined relationship is established among the battery voltage during discharge, the OCV, the discharge current, and the battery resistance. By reflecting the discharge characteristic information (discharge current) and the battery state information (OCV, battery resistance) that affect the battery voltage in setting of the threshold value, it becomes possible to detect abnormalities earlier and with higher accuracy.

The monitoring device 50 may use information on increase in resistance caused by concentration imbalance of ions that contribute to the battery reaction to set the threshold value. This enables to suppress false detection caused by increased resistance due to temporary deterioration, thereby improving reliability of detection of an abnormality.

The monitoring device 50 may use battery state information that is updated before flight by performing a battery state diagnosis while the aircraft is parked. The battery state information is updated for each flight. By using the battery state information that is updated for each flight, accuracy of detection of an abnormality can be further improved.

The setting unit 54 may successively change the threshold value to be set based on change in the battery state during flight. By successively changing the threshold value based on change in the battery voltage, an abnormality can be detected earlier and with higher accuracy.

The monitoring device 50 may acquire, as the voltage information, at least one of an absolute value of the assembled battery voltage Vb, an absolute value of the cell voltage Vc, the rate of change in the assembled battery voltage Vb, the rate of change in the cell voltage Vc, and the variation in the cell voltage Vc. By using the above parameters that respond sensitively to internal short circuit and sudden deterioration, an abnormality can be detected with high accuracy. In particular, by monitoring multiple parameters, it is possible to further improve the accuracy of detection of an abnormality.

The monitoring device 50 may acquire, as the voltage information, information relating to the assembled battery voltage Vb and information relating to the cell voltage Vc from respective different acquisition targets. For example, the assembled battery voltage information may be acquired from the EPU 15 and the cell voltage information may be acquired from the BMS 16. Reliability can be increased by monitoring using data from the different independent measurements, i.e., by multiplexing the diagnostics.

The monitoring device 50 may diagnose whether detection of an abnormality is being performed normally using the assembled battery voltage Vb and a total voltage obtained by adding up all the cell voltages Vc in the assembled battery 141. As a result, erroneous determination can be reduced.

In a predetermined period of time during the transition between the vertical movement and the horizontal movement, the monitoring device 50 may limit the detection of an abnormality, may apply the threshold value before the transition, and/or may apply the upper limit voltage or the lower limit voltage allowed for the battery 14 as the threshold value. This enables to suppress erroneous determination caused by normal sudden fluctuation in the battery voltage information, delay in battery voltage fluctuation due to normal transient response, and delay in switching of the threshold value. Therefore, reliability of detection of an abnormality can be improved.

The monitoring method of the present embodiment is executed by a processor to monitor the battery 14. A monitoring method includes acquiring the voltage information of the battery 14 and the travel mode information during flight, and outputting the monitoring result when a predetermined condition of an abnormality in the battery 14 is met with reference to the voltage information and the threshold value set for each travel mode. In this way, since a threshold value set for each travel mode is used, an abnormality in the battery 14 can be detected early. Thus, safety of flight can be enhanced.

The program is stored in the storage medium and includes instructions to be executed by the processor to monitor the battery 14. A program includes instructions for acquiring the voltage information of the battery 14 and the travel mode information during flight, and outputting the monitoring result when a predetermined condition of an abnormality in the battery 14 is met with reference to the voltage information and the threshold value set for each travel mode. In this way, since a threshold value set for each travel mode is used, an abnormality in the battery 14 can be detected early. Thus, safety of flight can be enhanced.

Other Embodiments:

The disclosure in this specification and drawings is not limited to the exemplified embodiments. The disclosure encompasses the illustrated embodiments and modifications by those skilled in the art based thereon. For example, the disclosure is not limited to the combinations of components and/or elements shown in the embodiments. The disclosure may be implemented in various combinations. The disclosure may have additional portions that may be added to the embodiments. The disclosure encompasses omission of components and/or elements of the embodiments. The disclosure encompasses the replacement or combination of components and/or elements between one embodiment and another. The disclosed technical scope is not limited to the description of the embodiments. Some aspects of the disclosed technical scope are indicated by the recitations of the claims, and should further be construed to include all modifications within the meaning and scope equivalent to those recitations.

The disclosure in the specification, drawings and the like is not limited by the description of the claims. The disclosures in the specification, the drawings, and the like encompass the technical ideas described in the claims, and further extend to a wider variety of technical ideas than those in the claims. Therefore, various technical ideas can be extracted from the disclosure of the specification, the drawings and the like without being limited to the description of the claims.

When an element or a layer is described as "disposed above" or "connected", the element or the layer may be directly disposed above or connected to another element or another layer, or an intervening element or an intervening layer may be present therebetween. In contrast, when an element or a layer is described as "disposed directly above" or "directly connected", an intervening element or an intervening layer is not present. Other terms used to describe the relationships between elements (for example, "between" vs. "directly between", and "adjacent" vs. "directly adjacent") should be interpreted similarly. As used herein, the term "and/or" includes any combination and all combinations relating to one or more of the related listed items. For example, the term A and/or B includes only A, only B, or both A and B.

Each of the various flowcharts shown in the present disclosure is an example, and the number of steps constituting the flowchart and the execution order of the process can be appropriately changed. The device, the system and the method therefor described in the present disclosure may be implemented by a dedicated computer which constitutes a processor programmed to perform one or more functions by executing computer programs. The device and the method described in the present disclosure may be also implemented by a dedicated hardware logic circuit. Furthermore, the device and the method thereof described in the present disclosure may be implemented by one or more special purpose computers formed by a combination of a processor that executes computer programs and one or more hardware logic circuits.

For example, a part or all of the functions of the processor 311 may be realized as hardware. An aspect in which a certain function is implemented as hardware includes an aspect in which one or multiple ICs are used. As the processor (arithmetic core), a CPU, an MPU, a GPU, a DFP, or the like can be adopted. The CPU is an abbreviation of a central processing unit. The MPU is an abbreviation of a micro-processing unit. The GPU is an abbreviation of a graphics processing unit. The DFP is an abbreviation of a data flow processor.

A part or all of the functions of the processor 201 may be implemented by combining multiple types of calculation processing devices. A part or all of the functions of the processor 201 may be implemented using an SoC, ASIC, FPGA, or the like. The SoC is an abbreviation of a system-on chip. The ASIC is an abbreviation of an application specific integrated circuit. The FPGA is an abbreviation of a field programmable gate array. The same applies to the processor 311.

The computer program may be stored in a computer-readable non-transitionary tangible recording medium (non-transitory tangible storage medium) as an instruction to be executed by the computer. As the program storage medium, an HDD, an SSD, a flash memory, or the like can be adopted. The HDD is an abbreviation of a hard disk drive. SSD is an abbreviation for Solid State Drive. The scope of the present disclosure also includes a program causing a computer to function as the controller or the control system, and forms such as a non-transitory tangible storage medium such as a semiconductor memory in which the program is stored.

(Disclosure of Technical Ideas)

This description discloses multiple technical ideas described in multiple items listed below. Some items may be written in a multiple dependent form with subsequent items referring to the preceding item as an alternative. Some items may be written in a multiple dependent form referring to another multiple dependent form. These items written in a multiple dependent form define multiple technical ideas.

(Technical idea 1)

A monitoring device is configured to monitor a battery (14) mounted on an electric flight vehicle (10). The monitoring device includes: an acquisition unit (51) configured to acquire voltage information of the battery during flight and information related to a travel mode of the electric flight vehicle; and an output unit (53) configured to output a monitoring result, when a predetermined condition related to an abnormality of the battery is satisfied with reference to the voltage information and a threshold value set for each of travel modes.

(Technical idea 2)

The monitoring device according to technical idea 1, in which a maximum discharge rate of the battery during vertical movement of the electric flight vehicle is 1.5 times or more than a maximum discharge rate during horizontal movement.

(Technical idea 3)

The monitoring device according to technical idea 2, in which the discharge rate during the vertical movement is 3C or more.

(Technical idea 4)

The monitoring device according to any one of technical ideas 1 to 3, in which the acquisition unit is configured to acquire, as the information related to the travel mode, discharge characteristic information of the battery and/or flight information.

(Technical idea 5)

The monitoring device according to technical idea 4, in which the acquisition unit is configured to acquire, as the information related to the travel mode, the discharge characteristic information and battery state information. The monitoring device further includes: a setting unit (54) configured to set the threshold value for each of travel modes based on the discharge characteristic information and the battery state information.

(Technical idea 6)

The monitoring device according to technical idea 5, in which the battery state information includes information on increase in resistance caused by concentration imbalance of ion that contribute to battery reaction.

(Technical idea 7)

The monitoring device according to technical idea 5 or 6, in which the setting unit is configured to use the battery state information that is updated before flight by diagnosis of a battery state performed when the electric flight vehicle is parked.

(Technical ides 8)

The monitoring device according to any one of technical ideas 5 to 7, in which the setting unit is configured to successively change the threshold value to be set based on change in a battery state during flight.

(Technical idea 9)

The monitoring device according to any one of technical ideas 1 to 8, in which the battery includes an assembled battery (141) including a plurality of battery cells (142), and the acquisition unit is configured to acquire, as the voltage information, at least one of an absolute value of an assembled battery voltage, an absolute value of a cell voltage, a rate of change in the assembled battery voltage, a rate of change in the cell voltage, and a variation in the cell voltage.

(Technical idea 10)

The monitoring device according to technical idea 9, in which the acquisition unit is configured to acquire, as the voltage information, information on the assembled battery voltage and information on the cell voltage from respective different acquisition targets.

(Technical idea 11)

The monitoring device according to technical idea 10, further includes: a diagnosis unit (52) configured to diagnose whether detection of an abnormality is being performed normally with reference to the assembled battery voltage and a total voltage acquired by adding up all cell voltages in the assembled battery.

(Technical idea 12)

The monitoring device according to any one of technical ideas 1 to 11, further includes: a limiting unit (52) configured to perform, during a predetermined period in transition between vertical movement and horizontal movement, limiting detection of an abnormality, applying the threshold value before the transition, or applying, as the threshold value, an upper limit voltage or a lower limit voltage allowed for the battery.

**Claims**

1. A monitoring device configured to monitor a battery (14) mounted on an electric flight vehicle (10), the monitoring device comprising:

   an acquisition unit (51) configured to acquire voltage information of the battery during flight and information related to a travel mode of the electric flight vehicle; and
   an output unit (53) configured to output a monitoring result, when a predetermined condition related to an abnormality of the battery is satisfied with reference to the voltage information and a threshold value set for each of travel modes.

2. The monitoring device according to claim 1, wherein
   a maximum discharge rate of the battery during vertical movement of the electric flight vehicle is 1.5 times or more than a maximum discharge rate during horizontal movement.

3. The monitoring device according to claim 2, wherein
   the discharge rate during the vertical movement is 3C or more.

4. The monitoring device according to claim 1, wherein
   the acquisition unit is configured to acquire, as the information related to the travel mode, discharge characteristic information of the battery and/or flight information.

5. The monitoring device according to claim 4, wherein

   the acquisition unit is configured to acquire, as the information related to the travel mode, the discharge characteristic information and battery state information,
   the monitoring device further comprising:
   a setting unit (54) configured to set the threshold value for each of travel modes based on the discharge characteristic information and the battery state information.

6. The monitoring device according to claim 5, wherein
   the battery state information includes information on increase in resistance caused by concentration imbalance of ion that contribute to battery reaction.

7. The monitoring device according to claim 5, wherein
   the setting unit is configured to use the battery state information that is updated before flight by diagnosis of a battery state performed when the electric flight vehicle is parked.

8. The monitoring device according to any one of claims 5 to 7, wherein
   the setting unit is configured to successively change the threshold value to be set based on change in a battery state during flight.

9. The monitoring device according to claim 1, wherein

   the battery includes an assembled battery (141) including a plurality of battery cells (142), and
   the acquisition unit is configured to acquire, as the voltage information, at least one of an absolute value of an assembled battery voltage, an absolute value of a cell voltage, a rate of change in the assembled battery voltage, a rate of change in the cell voltage, **and** a variation in the cell voltage.

10. The monitoring device according to claim 9, wherein
    the acquisition unit is configured to acquire, as the voltage information, information on the assembled battery voltage and information on the cell voltage from respective different acquisition targets.

11. The monitoring device according to claim 10, further comprising:
    a diagnosis unit (52) configured to diagnose whether detection of an abnormality is being performed normally with reference to the assembled battery voltage and a total voltage acquired by adding up all cell voltages in the assembled battery.

12. The monitoring device according to claim 1, further comprising:
a limiting unit (52) configured to perform, during a predetermined period in transition between vertical movement and horizontal movement,

limiting detection of an abnormality,
applying the threshold value before the transition, or
applying, as the threshold value, an upper limit voltage or a lower limit voltage allowed for the battery.

13. A monitoring method configured to be executed by a processor (201) for monitoring a battery (14) mounted on an electric flight vehicle (10), the monitoring method comprising:

acquiring voltage information of the battery during flight and information related to a travel mode of the electric flight vehicle; and
outputting a monitoring result, when a predetermined condition related to an abnormality of the battery is satisfied with reference to the voltage information and a threshold value set for each of travel modes.

14. A program stored in a storage medium (203) and configured to be executed by a processor (201) for monitoring a battery (14) mounted on an electric flight vehicle (10), the program comprising instructions to execute:

acquiring voltage information of the battery during flight and information related to a travel mode of the electric flight vehicle; and
outputting a monitoring result, when a predetermined condition related to an abnormality of the battery is satisfied with reference to the voltage information and a threshold value set for each of travel modes.

FIG. 1

EP 4 730 480 A1

# FIG. 2

GROUND STATION 30
SERVER 31
EXTERNAL MANAGEMENT UNIT 41

eVTOL 10
ECU 20
INTERNAL MANAGEMENT UNIT 42

40

EP 4 730 480 A1

# FIG. 3

142P  142N  IV ←  141, 14

142

IV ←

Z ↑ → X

# FIG. 4

142P 142P 142P 142P 142P 142P 142P 142P

142N 142N 142N 142N 142N 142N 142N 142N 142N  141, 14

142 142 142 142 142 142 142 142

142 142 142 142 142 142 142 142 142

Z ↑ → Y

# FIG. 5

142P 142N 142N 142N

142P 142P

Z Y X

EP 4 730 480 A1

# FIG. 6

# FIG. 7

# FIG. 8

# FIG. 9

# FIG. 10

# FIG. 11

# FIG. 12

# FIG. 13

# FIG. 14

# FIG. 15

# FIG. 16

```
              ┌──────────────┐
              │    START     │
              └──────┬───────┘
                     │
                     ▼
        ┌──────────────────────────────┐
        │     ACQUIRE INFORMATION       │  ~ S10
        │ · TRAVEL MODE INFORMATION     │
        │ · VOLTAGE INFORMATION         │
        └──────────────┬───────────────┘
                       │
                       ▼
        ┌──────────────────────────────┐
        │        SET THRESHOLD          │  ~ S20
        └──────────────┬───────────────┘
                       │
                       ▼                    S30
                 ◇ VOLTAGE ◇
              INFORMATION OUT OF          NO
              ALLOWABLE THRESHOLD  ──────────┐
                   RANGE?                    │
                     │ YES                   │
                     ▼                       │
        ┌──────────────────────────────┐    │
        │      OUTPUT ABNORMALITY       │ ~ S40
        └──────────────┬───────────────┘    │
                       │◄───────────────────┘
                       ▼
              ┌──────────────┐
              │     END      │
              └──────────────┘
```

# FIG. 17

```
                    ┌─────────────┐
                    │    START    │
                    └──────┬──────┘
                           │
                           ▼
        ┌───────────────────────────────────┐
        │        ACQUIRE INFORMATION        │      S10
        │   · TRAVEL MODE INFORMATION       │
        │   · VOLTAGE INFORMATION           │
        └─────────────────┬─────────────────┘
                          │
                          ▼                   S15
                    ╱─────────────╲
                 ╱   OUT OF          ╲      NO
                ╱  PREDETERMINED TIME  ╲──────────┐
                ╲  IN TRANSITION?      ╱          │
                 ╲                   ╱            │
                    ╲─────┬───────╱               │
                          │ YES                   ▼
                          ▼                 ┌──────────────┐
        ┌───────────────────────┐          │ LIMIT MONITOR│  S21
        │     SET THRESHOLD     │  S20     └──────┬───────┘
        └───────────┬───────────┘                 │
                    │                              │
                    ▼◄─────────────────────────────┘
                    ╱─────────────╲         S30
                 ╱   VOLTAGE         ╲
                ╱  INFORMATION OUT OF  ╲    NO
                ╲  ALLOWABLE THRESHOLD ╱──────────┐
                 ╲  RANGE?           ╱            │
                    ╲─────┬───────╱               │
                          │ YES                   │
                          ▼                        │
        ┌───────────────────────┐                 │
        │   OUTPUT ABNORMALITY  │  S40            │
        └───────────┬───────────┘                 │
                    │◄────────────────────────────┘
                    ▼
                ┌─────────┐
                │   END   │
                └─────────┘
```

## FIG. 18

## FIG. 19

# FIG. 20

```
                    ┌──────────────┐
                    │    START     │
                    └──────┬───────┘
                           │
              ┌────────────┴────────────┐
              │   ACQUIRE INFORMATION   │ ～ S10
              │ · TRAVEL MODE INFORMATION│
              │ · VOLTAGE INFORMATION   │
              └────────────┬────────────┘
                           │
              ┌────────────┴────────────┐
              │      SET THRESHOLD      │ ～ S20
              └────────────┬────────────┘
                           │
                           │           S25
                    ╱──────┴──────╲
                   ╱  DIFFERENCE ≤ ╲      NO
                  ╱ PREDETERMINED   ╲───────────┐
                  ╲   VALUE         ╱           │
                   ╲       ?       ╱            │
                    ╲──────┬──────╱             │
                           │ YES               │
                           │        S30        │
                    ╱──────┴──────╲            │
          NO       ╱   VOLTAGE     ╲           │
     ┌────────────╱ INFORMATION OUT ╲          │
     │            ╲ OF ALLOWABLE    ╱          │
     │             ╲THRESHOLD RANGE?╱          │
     │              ╲──────┬──────╱            │
     │                     │ YES               │
     │          ┌──────────┴─────────┐  ┌──────┴──────────────┐
     │          │ OUTPUT ABNORMALITY │  │  OUTPUT MONITOR     │
     │          └──────────┬─────────┘  │ ABNORMALITY POSSIBILITY│ ～ S41
     │                     │     S40     └──────┬──────────────┘
     └─────────────────────┼────────────────────┘
                           │
                    ┌──────┴───────┐
                    │     END      │
                    └──────────────┘
```

## INTERNATIONAL SEARCH REPORT

| International application No. |
|---|
| **PCT/JP2024/017891** |

**A. CLASSIFICATION OF SUBJECT MATTER**

***H01M 10/48***(2006.01)i; ***B64D 27/24***(2024.01)i; ***B64U 50/19***(2023.01)i; ***B64U 80/20***(2023.01)i; ***H02J 7/00***(2006.01)i
FI: H01M10/48 P; B64D27/24; B64U50/19; B64U80/20; H02J7/00 Y

According to International Patent Classification (IPC) or to both national classification and IPC

**B. FIELDS SEARCHED**

Minimum documentation searched (classification system followed by classification symbols)

H01M10/48; B64D27/24; B64U50/19; B64U80/20; H02J7/00

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| X | JP 2016-210403 A (ORBITAL WORKS K.K.) 15 December 2016 (2016-12-15) paragraphs [0010]-[0036], fig. 1 | 1-8, 12-14 |
| Y | | 9-11 |
| Y | JP 2008-92656 A (SANYO ELECTRIC CO., LTD.) 17 April 2008 (2008-04-17) paragraph [0045], fig. 1 | 9-11 |
| A | WO 2021/176580 A1 (MITSUBISHI ELECTRIC CORPORATION) 10 September 2021 (2021-09-10) entire text, all drawings | 1-14 |

☐ Further documents are listed in the continuation of Box C.　☑ See patent family annex.

| | |
|---|---|
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "D" document cited by the applicant in the international application | "X" document of particular relevance; the claimed invention cannot be considered novel or cannot be considered to involve an inventive step when the document is taken alone |
| "E" earlier application or patent but published on or after the international filing date | |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **13 June 2024** | **25 June 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

## INTERNATIONAL SEARCH REPORT
### Information on patent family members

| | International application No. |
| --- | --- |
| | **PCT/JP2024/017891** |

| Patent document cited in search report | | | Publication date (day/month/year) | Patent family member(s) | Publication date (day/month/year) |
| --- | --- | --- | --- | --- | --- |
| JP | 2016-210403 | A | 15 December 2016 | (Family: none) | |
| JP | 2008-92656 | A | 17 April 2008 | (Family: none) | |
| WO | 2021/176580 | A1 | 10 September 2021 | US 2023/0057522 A1 entire text, all drawings EP 4117175 A1 | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2023097930 A
- JP 2021172101 A